# DEMANDE DE BREVET EUROPEEN

(11) **EP 0 631 462 A1**
(43) Date de publication de la demande: **28.12.1994**
(21) Numéro de dépôt: 94401330.9
(22) Date de dépôt: 14.06.1994
(51) Int. Cl.: H05K 7/14, H05K 5/02

(54) **Appareil d'automatisation à montage de sécurité**

(30) Priorité: 25.06.1993 FR 9307874
(71) Demandeur: AEG SCHNEIDER AUTOMATION, F-06560 Valbonne (FR)
(72) Inventeur: Chabert, Jean-Marie, F-06560 Valbonne (FR); Goletto, André, F-06600 Antibes (FR)
(74) Mandataire: Carias, Alain

(57) **Abrégé**

Le boîtier 10 du module d'interface comporte un levier pivotant 30 capable de masquer ou libérer, selon la position du bornier de câblage 20, une vis 12 de fixation au support 11.

## Description

La présente invention concerne un appareil d'automatisation améliorant la sécurité du personnel qui en assure l'installation, l'exploitation ou la maintenance.

Certains appareils d'automatisation, tels que des automates programmables ou autres appareils de commande industrielle, se composent de modules d'interface communiquant d'une part avec le système automatisé, d'autre part avec une unité centrale qui ordonnance le fonctionnement du système en fonction des instructions d'un programme. Les modules sont juxtaposés et fixés à l'arrière sur un profilé, une platine ou autre support de montage et reçoivent à l'avant des borniers câblés à des circuits d'alimentation et à des organes capteurs ou actionneurs qui appartiennent au système automatisé.

La platine de montage est mise à la terre et posséde par exemple, à cet effet, une borne normalisée spécifique pour la connexion d'un conducteur de protection. Les modules d'interface sont rapportés de façon amovible à la platine par des moyens de fixation, par exemple une ou deux vis de fixation, et possèdent à l'arrière au moins un contact élastique de protection applicable sur la platine. Ainsi, lorsque les modules sont fixés à la platine, leurs contacts élastiques assurent la nécessaire mise à la terre du module.

D'autre part, les borniers fixés aux modules assurent par des connexions électriques appropriées l'alimentation électrique des modules et la transmission de signaux d'entrée ou de sortie entre le système automatisé et les modules.

Lorsqu'un opérateur démonte le module d'interface de la platine, en dévissant sa vis ou ses vis de fixation et en éloignant le module de la platine, sans avoir préalablement séparé le bornier du module, il risque de maintenir le module sous tension puisque celui-ci reste connecté au système automatisé alors qu'il n'est plus relié à la terre par la platine.

L'invention a pour but d'améliorer la sécurité d'installation, d'utilisation et de maintenance d'un appareil d'automatisation du type décrit en préambule, par une disposition simple qui interdit le démontage du module d'interface de la platine tant que le bornier reste fixé au module.

Selon l'invention,
- le boîtier d'interface est muni d'un moyen mobile de masquage de l'accès aux moyens de fixation,
- le moyen de masquage coopére avec une portée accessible par la face avant du boîtier et déplaçable par le bornier de câblage, pour assurer le masquage quand le bornier est appliqué sur le boîtier d'interface.

On est ainsi certain que l'opérateur ne pourra pas séparer le module d'interface de son support tant que le bornier de câblage n'aura pas été préalablement ôté.

La description qui suit d'un mode de réalisation non limitatif illustre les caractéristiques et avantages de l'invention.

La figure 1 montre très schématiquement en vue de côté un automate programmable conforme à l'invention.

La figure 2 représente en perspective avec arrachement une partie du module d'interface.

Les figures 3 et 4 montrent en vue de côté le module d'interface, le bornier étant fixé au module et respectivement séparé de celui-ci.

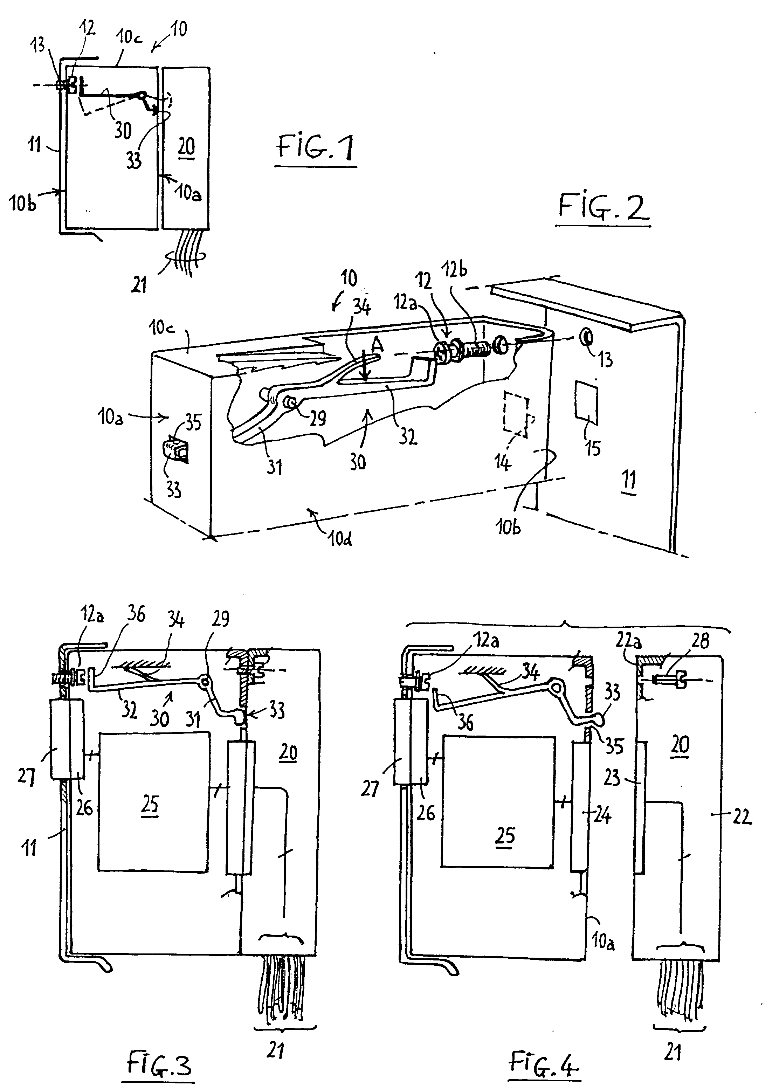

L'appareil d'automatisation illustré sur la figure 1 est un automate programmable prévu pour commander un système automatisé tel qu'une machine, un dispositif, un processus, etc.... Bien entendu, l'appareil d'automatisation peut être constitué par un ensemble de commande numérique susceptible d'être câblé à un système automatisé pour le contrôler ou le commander.

L'appareil comprend un ou plusieurs modules d'interface dont chacun comporte un boîtier 10 de forme générale parallélépipédique. Le boîtier comprend ainsi une face avant 10a, une face arrière 10b, une face supérieure 10c et des faces latérales 10d. Le boîtier d'interface 10 peut être fixé du côté de sa face arrière 10b à un support 11 tel qu'une platine, une plaque ou un socle par des moyens de guidage et de fixation comprenant une vis unique de fixation 12 située à sa partie supérieure. La vis 12 possède une tête 12a accessible par la face avant 10a ou la face supérieure 10c du boîtier 10 et une tige filetée 12b qui doit s'engager dans un orifice taraudé ou un écrou 13 du support 11.

La face arrière 10b du boîtier et le support 11 présentent des parties métalliques 14,15 qui, lorsque le module est fixé au support, sont en contact électrique mutuel pour assurer la mise à la terre d'éléments constitutifs du module ou connectés à celui-ci cette mise à la terre s'effectue par une liaison ou un conducteur de terre associé au support 11. La partie métallique 15 peut être la plaque de support elle-même ou bien un rail métallique adjoint au support.

Un bornier de câblage 20 logeant des départs de câbles 21 vers des capteurs ou actionneurs propres au système automatisé présente un corps 22 muni d'une face de couplage 22a applicable sur la face avant 10a du module et d'un connecteur 23 relié aux câbles 21 et couplable à un connecteur avant 24 du module d'interface. De plus, les connecteurs 23,24 ou d'autres moyens de connexion assurent la liaison d'alimentation des circuits d'entrées-sorties du module d'interface via le bornier. Dans le module d'interface le connecteur 24 est relié à un circuit d'entrées-sorties et de traitement 25 lui-même relié à un connecteur arrière 26, couplable à un connecteur 27 associé au support pour assurer la liaison avec une unité centrale de traitement et avec les autres modules. La fixation du corps de bornier 20 au boîtier d'interface 10 s'effectue par tous moyens usuels, par exemple une vis 28.

Dans le boîtier d'interface 10 est monté pivotant sur un tourillon fixe 29 un levier 30 à deux bras 31,32. Le bras 31 se termine par une portée 33 qui peut faire saillie, sous l'effet d'un ressort 34 sollicitant le levier selon la flèche A, vers l'avant du boîtier 10 et au-delà de sa face avant 10a, par une fenêtre 35 de cette face avant. Le bras 32 présente à son extrémité libre une facette de masquage 36 susceptible de cacher ou libérer l'accès à la tête 12a de la vis en fonction de la position du levier 30 et de sa portée 33. Dans le présent mode de réalisation, le ressort 34 est constitué par un troisième bras élastique du levier 30.

Le dispositif décrit fonctionne de la manière suivante. Lorsque le corps du bornier 20 est appliqué et/ou fixé contre le boîtier d'interface 10 (figure 3), la face 22a du bornier est appliquée contre la portée 33 du levier, dont la facette 36 vient ainsi occulter l'accès à la tête de la vis 12. Il est alors impossible de démonter le module d'interface de son support 11.

Lorsque le bornier 20 est retiré du module d'interface (figure 4), la portée 33 fait saillie à travers la fenêtre 35 puisque le levier est sollicité par le ressort 34. Il en résulte que la facette 36 démasque l'accès à la tête 12a de la vis, qui peut être desserrée afin de permettre de séparer le module d'interface de son support.

Le dispositif à levier décrit peut bien sûr être remplacé par tout dispositif équivalent, par exemple utilisant un poussoir pour détecter la présence du bornier, ce poussoir coopérant avec un levier porteur de l'élément de masquage ou d'obturation.

## Revendications

1. Appareil d'automatisation tel qu'un automate programmable comprenant :
- au moins un module d'interface qui comporte un boîtier susceptible d'être attaché vers sa face arrière par des moyens de fixation à un support relié à la terre,
- un bornier de câblage à fixer à une face avant du boîtier,
caractérisé par le fait que
- le boîtier d'interface (10) est muni d'un moyen mobile de masquage de l'accès aux moyens de fixation (12),
- le moyen de masquage coopère avec une portée (33) accessible par la face avant (10a) du boîtier et déplaçable par le bornier de câblage (20), pour assurer le masquage quand le bornier est appliqué sur le boîtier d'interface.

2. Appareil selon la revendication 1, caractérisé par le fait que le moyen de masquage (36) comprend un levier (30) capable de pivoter sur un tourillon (29) du boîtier (10) et présentant un premier bras (31) qui se termine par la portée (33) commandable par le bornier et un deuxième bras (32) qui se termine par une facette de masquage (36).

3. Appareil selon la revendication 1, caractérisé par le fait que les moyens de fixation sont constitués par une vis unique (12) située à la partie supérieure du boîtier d'interface (10) et dont la tête (12a) est susceptible d'être cachée par le moyen de masquage (36).
